# EUROPEAN PATENT APPLICATION

(11) **EP 4 832 680 A1**
(43) Date of publication of application: **28.10.2026**
(21) Application number: 25172569.3
(22) Date of filing: 25.04.2025
(51) Int. Cl.: H05K 7/20

(54) **FLUID FLOW SYSTEM FOR A FLUID WITH DUAL PURPOSE IN A VEHICLE**

(71) Applicant: AIRBUS Operations GmbH, 21129 Hamburg (DE)
(72) Inventor: Mueller, Jan, 21129 Hamburg (DE); Fischer, Wolfgang, 21129 Hamburg (DE); Heinke, Burkhard, 21129 Hamburg (DE)
(74) Representative: Airbus Germany

(57) **Abstract**

The present disclosure relates to a fluid flow system for a fluid with dual purpose in a vehicle, comprising a heat-emitting electronic component, configured to attach to a fluid-flow device in a heat-transferring manner; the fluid-flow device having an exchange surface in contact with the fluid, wherein the fluid-flow device is configured to guide the fluid and transfer heat from the exchange surface to the fluid to generate heated fluid; The system further comprises a thermal sink configured to hold a fluid volume, intake the heated fluid from the fluid-flow device and dissipate the heat of the heated fluid in the fluid volume; wherein the fluid is configured to enable a primary vehicle function which is independent from absorbing heat from the heat-emitting electronic component.

## Description

The present invention relates to managing the flow of a fluid with a primary function and a secondary function as a cooling fluid to control the temperature of electronic components in a vehicle, specifically an aircraft. The fluid flow can be adapted in relation to the electronic components to integrate with an existing fluid system.

Cooling electronic equipment of vehicles, specifically devices in the cabin crown areas of an aircraft, is crucial for maintaining the performance and reliability of onboard systems. The cabin crown area, typically located above the passenger cabin may house various electronic components, including avionics, communication systems, and inflight entertainment equipment. Effective cooling is essential to prevent overheating and reduce the potential of malfunctions occurring.

Heat from the electronic components can be removed by ventilation systems or passive convection through the compartment housing the components. Specifically, in electronic bays in an aircraft cooling of the components can rely on passive convection using heat sinks.

**In** an aircraft, components in electronics bays are typically mounted in areas without forced cooling, thereby solely relying on passive convection and ambient temperatures. With increasing thermal load, the use of heat sinks only can be disadvantageously. Scaling heat sinks according to the thermal load may add weight, increase cost, and size of the equipment. Effectiveness of heat sinks can be limited in areas with low natural air convection, as the heat dissipation relies heavily on the movement of air around the heat sink.

To enhance cooling efficiency, active cooling methods such as fans can be employed. Fans may increase the airflow inside and/or around the electronic component, thereby improving heat dissipation. However, the use of fans introduces several challenges. Fans may require dust filters to prevent the accumulation of dust on the components, which can impede airflow and reduce cooling efficiency. Additionally, these filters may require regular maintenance to ensure optimal performance, thereby increasing maintenance cost. Moreover, applying fans may impact vehicle safety measures. For example, adding fans may require counter measures to prevent or at least limit unintentional spreading of smoke or toxic gases from a malfunctioning device. Therefore, adding fans may add complexity to the design and increases the overall cost and maintenance requirements of a cooling system for electronic components in a vehicle.

In liquid cooling solutions, typically applied to high performance computing devices a dedicated coolant is used to absorb and dissipate heat from components. These dedicated systems are highly effective at managing heat but may in turn incur substantial additional cost and weight. Also liquid cooling solutions may impose additional design challenges in fluid line routing and providing a suitable heat exchanger.

Cooling electronic components in aircraft presents unique challenges due to the demanding operational environment. Aircraft electronics, or avionics, must function reliably under varying conditions, including extreme temperatures, high humidity, and/or significant mechanical stress. Similar requirements apply to cooling solutions for these components. Further, compliance with aviation standards and regulations may be an additional requirement.

It is therefore an objective according to the present disclosure to provide a cooling system suitable for a vehicle, specifically an aircraft, that enables heat transfer from electronics and balances efficiency, reliability, and compliance requirements

The present disclosure relates to a fluid flow system for a fluid with dual purpose within an aircraft. Electronic components and corresponding mounting means are configured to thermally interface with the primary fluid system, specifically the high pressure water system of the aircraft to enable cooling the electronic components, in particular in the crown area. The additional heat can reduce heating requirements at the water reservoir to prevent freezing.

According to a first aspect, the present disclosure relates to a fluid flow system for a fluid with dual purpose in a vehicle. The system comprises a heat-emitting electronic component, which is configured to attach to a fluid-flow device in a heat-transferring manner. The system can further comprise a fluid-flow device having an exchange surface in contact with the fluid. The fluid-flow device is configured to guide the fluid; and transfer heat from the exchange surface to the fluid to generate heated fluid. Further, the system comprises a thermal sink which is configured to hold a fluid volume, intake the heated fluid from the fluid-flow device, and/or dissipate the heat of the heated fluid in the fluid volume.

The proposed system offers several advantages over the current state of the art in cooling electronic devices. One of the primary benefits is the significant weight savings achieved through a smaller form factor for the equipment. The efficient cooling can handle increased thermal loads and thereby enable higher processing power within the devices. Additionally, the use of an already existing system, preferably a High Pressure Water System (HPWS), for cooling further enhances the efficiency.

Furthermore, the system facilitates increased ease of installation as standardized connectors of the existing fluid system can be used. The electronic components can be designed with a standardized heat transfer interface to enable efficient mounting to a corresponding plate, in particular in a crown area of an aircraft. This standardization may reduce the variety of parts speed up the installation process.

A HPWS in an aircraft may require a heater to prevent the water in the central tank from freezing during flight. Introducing the heat from the electronic components can increase the temperature, thereby helping to avoid freezing within tanks or pipes of the HPWS.

The fluid is configured to enable a primary vehicle function which is independent from absorbing heat from the heat-emitting electronic component.

The system is designed to control and manage the flow and temperature of a fluid within a vehicle. The system comprises components that facilitate moving, heating, cooling, and storing fluids. The vehicle can be configured for any type of travel: aircraft, spacecraft, motor vehicles, watercraft, rail vehicles.

The heat-emitting electronic component can be an electronic device or part that generates heat during its operation. Examples include CPUs, power converters, power amplifiers, aircraft specific control modules, and other electronic devices. The component may have a need for cooling to maintain its function, specifically to achieve optimal performance and/or maintain its operational status. The component may require cooling means to prevent overheating and enable longer lifetime. The component can be a complex electronic device performing a specific task related to operating the vehicle, providing a vehicle function and/or a function related to a vehicle passenger and/or a vehicle load.

The electronic component can comprise a mechanical, electrical and/or thermal interface to the vehicle. The mechanical interface can be configured to attach the electric component to the fluid-flow device to lock the electronic in a fixed position. The electrical interface can be configured to allow electric energy transfer and/or the transfer of electric signals between the electronic component and other components of the vehicle. The thermal interface can be configured to transfer heat to a surface of the electronic component. Preferably to a surface of the electronic component which is connected to the fluid-flow device in a heat-transferring manner.

For example, an outer housing surface may be mechanically coupled to the fluid-flow device so that heat transfer is achieved between the electronic component and the fluid-flow device eventually the fluid. The fluid-flow device can be a structural part of the vehicle, specifically the vehicle installation, e.g., a bracket, an installation plate, etc.). Preferably, the electronic component can be clipped, screwed, glued to the structural part. Thereby, the advantage can be achieved, that a fluid circuit can be fluidly decoupled from the electronic component and the risk of leaks can be minimized.

The electronic and mechanical interface can be spatially separated from a cooling interface.

Attaching to the fluid-flow device in a heat-transferring manner can be defined as establishing a material contact between the two elements, i.e., by providing a surface-to-surface contact. Any means to increase thermal conductivity at the contact surfaces can be applied.

The fluid-flow device can be a pipe or channel that directs the flow of fluid within the system. The fluid-flow device can be configured to integrate into an existing fluid-carrying system. The fluid-flow device can be configured to integrate into any existing suitable vehicle system or a dedicated system for cooling. These systems can comprise fuel lines, water-supply lines, coolant hoses, air flow and/or hydraulic lines. The fluid-flow device can be capable of transferring heat from its walls to the fluid inside the fluid-flow device. Preferably, the water supply system can be adapted to enable a constant flow through the fluid-flow device. Specifically, a potable water supply system can be adapted to include a water circulation loop including the fluid-flow device. Existing components, i.e., the potable water reservoir can be used to absorb the heat transferred into the system from the electronic component via the fluid-flow device.

Preferably, the fluid-flow device is designed to direct the fluid flow in a manner that facilitates the transfer of heat from the conduit walls to the fluid, resulting in the fluid becoming heated. Thereby, the thermal energy within the electronic component can be transport away .

The fluid-flow device can be configured to be chemically compatible with the fluid such that the fluid-flow device may not influence the use of the fluid in its primary function. Specifically, the fluid-flow device can be configured corrosion and degradation resistant.

The exchange surface can be configured to guide, respectively hold the fluid. For example, a liquid can be guided through a tubelike structure. Thereto, the fluid-flow device can comprise a fluid conduit which can be configured as a tube, a pipe or a hose. The fluid conduit can be flexible or rigid. Alternatively, when considering a gas, the exchange surface can be open. Guiding the fluid can refer to constraining the fluid flow within the fluid-flow device and/or setting a preferred flow direction according to the structure of the fluid-flow device. Preferably, transferring heat from the fluid-flow device to the fluid can be realized via conductive and/or radiative heat transfer.

The fluid can be any substance that continuously deforms, i.e., flows under an applied shear stress, specifically regardless of the magnitude of the stress. The fluid can encompass liquids and/or gases. The fluid can be compressible, e.g., air or nearly incompressible, e.g., water, hydraulic liquid, oil and/or fuel. Concerning mixtures, the fluid can comprise an aerosol, emulsion and/or foam.

The fluid can be initially integrated into the system, respectively the vehicle, to perform a specific primary function, such as lubrication, hydraulic actuation, propulsion fuel, and/or potable water supply. **It** maintains its primary role without compromising its effectiveness or reliability. The fluid can additionally be used to absorb and dissipate heat from electronic components, thereby preventing overheating and ensuring optimal performance.

The fluid can be expandable such that the total amount of fluid within the system may change. The fluid may be subject to refuelling before complete expenditure or before a fill level drops below a predetermined threshold. Thereto, the system can be thermodynamically open. Specifically, the heat transferred to the fluid can be removed from the system by removing at least part of the fluid from the system. Examples include fuel being ignited in the engine or water used by passengers of the vehicle.

Preferably, the fluid possesses properties that enable efficient heat absorption and transfer, such as high thermal conductivity and specific heat capacity. However, the fluid-flow device can be adapted with regard to thermal requirements of the electronic component and the properties of the available fluid to enable a sufficient heat transfer from the electronic component to the fluid.

The dual-purpose use of the fluid enhances overall system efficiency by reducing the need for separate cooling systems or at least reduce the size of additional cooling systems.

The fluid can be a primary component of a primary vehicle function, i.e., the fluid can be essential to executing the primary vehicle function. Thereto, the fluid can have a primary purpose as a functional medium for the vehicle function, in particular independent of its function as a coolant for the heat-emitting electronic component.

The fluid can have a primary purpose as an expendable medium within the vehicle. As a secondary purpose or function the fluid can serve as a heat exchange medium for the heat-emitting component. Thereto, the fluid's additional role can be to absorb and transfer heat away from the electronic component, acting as a cooling medium.

The primary function can relate to steering, engine cooling, vehicle compartment climatization / temperature control and/or pressurization, propulsion, water provisioning.

The fluid can be a primary working fluid of a vehicle function independent from cooling the electronic component. The primary function can also be a cooling function. For example, the vehicle can comprise a dedicated and/or centralized climatization system. Thereto, the fluid flow can be adjusted to integrate the fluid-flow device into the climatization system. The fluid-flow device can be integrated with a working fluid circuit of the climatization system. Alternatively, the fluid-flow device can be flowed through by a fluid cooled by the climatization system.

The thermal sink can be a device designed to absorb and dissipate heat, containing a specific volume of fluid. The thermal sink can be configured to use the fluid to manage and distribute thermal energy within the vehicle. Preferably, the thermal sink is a fluid reservoir, wherein the fluid volume held by the thermal sink is substantially larger than the fluid volume within connecting pipes and/or within the fluid-flow device. For example, the thermal sink can be a cabin compartment, a fuel tank or a reservoir of potable water.

The thermal sink can be configured to dissipate heat to the atmosphere. Specifically, the thermal sink can be subject to reduced temperatures during the operation of the vehicle, e.g., an aircraft at high altitude.

Heat intake into the thermal sink can be achieved by fluid flowing from the fluid-flow device into the heat sink. Dissipating heat in the thermal sink can refer to mixing the heated fluid from ejected from the fluid-flow device into the larger fluid volume held in the heat sink.

Thereto, outflow from the fluid-flow device can be directed towards the thermal sink. Thus, the thermal sink can be configured to receive the heated fluid from the fluid-flow device, allowing the fluid to enter the thermal sink for further thermal management.

The thermal sink can be configured to disperse the thermal energy contained in the heated fluid throughout its fluid volume. This process may involve distributing the fluid within the thermal sink to maximize heat dissipation. The heat sink may further dissipate the heat through a wall surface in contact with a structure or atmosphere with a temperature below the fluid temperature in the heat sink.

In a further embodiment, the fluid-flow device can be configured to generate a convective fluid flow through the fluid-flow device based on a temperature difference between the exchange surface and the fluid in the fluid-flow-device. This can achieve the advantage that passive convection can occur in the fluid-flow device moving fluid through the fluid-flow device.

In a further embodiment, the fluid transport device can be configured to generate a fluid flow and loop the fluid between the fluid-flow device and the thermal sink.

Preferably, the fluid transport device can be a pump. The fluid transport device can be a mechanical device that moves fluids through the system by creating a pressure difference. The fluid transport device in the present system is responsible for circulating the fluid between the fluid-flow device and the thermal sink.

The fluid transport device can be configured to maintain a fluid flow velocity above a predetermined threshold velocity such that the fluid remains in a predefined phase. The fluid flow velocity can be an average flow velocity or an instantaneous flow velocity. Specifically, the fluid flow can be high enough such that the fluid neither boils, freezes nor loses its integrity.

Thereto the system can comprise a control, specifically, a flow velocity, temperature and/or pressure control configured to monitor fluid properties and adjust the fluid transport device accordingly to keep the fluid within predetermined parameters.

Looping the fluid can refer to circulating a fluid in a fluid flow loop including at least the fluid-flow device, heat sink and fluid transport device.

The fluid can be circulated through the system using existing and/or additional fluid transport device. The fluid transport device can be configured to ensure continuous or intermittent movement of the fluid and thereby manage heat exchange.

The fluid transport device can be configured to maintain a pressure of a pressurized subsection of the fluid circuit. Thereto a suitable pressure for dispensing water can be maintained. The fluid-flow device can be disposed in the pressurized subsection. Preferably, the heat sink is disposed in a low pressure section of the fluid loop. Advantageously a pressure regulator can mediate between differently pressurized fluid circuit sections.

In a further embodiment, the fluid-flow device can comprise an inlet configured to receive fluid, and an outlet configured to eject the fluid. The fluid transport device can be configured to provide at least part of the fluid to the inlet from a vehicle exterior, and/or to recirculate at least part of the fluid exiting the outlet to the inlet via the thermal sink.

This can achieve the advantage that cooled fluid from the atmosphere can be injected into the fluid system to efficiently cool the electronic component. Further, heat can be removed by ejecting heated fluid from the vehicle.

In an embodiment, the system can comprise a pressure regulator configured to provide the heated fluid at ambient pressure to the thermal sink.

This can achieve the advantage that the fluid reservoir can be open to the surrounding atmosphere. The pressure regulator can be disposed between the heat sink and the fluid-flow device. Alternatively, the pressure regulator can be disposed upstream of the fluid-flow device. This may achieve the advantage that the fluid-flow device is at a reduced pressure which may lower minimum material specifications for connections, fittings, etc.

In a further embodiment the system can comprise a fluid tapping point configured to remove a portion of the fluid from the fluid flow system. The fluid transport device can be configured to apply a pressure to downstream fluid that exceeds ambient pressure of the fluid-flow system such that at least at the fluid tapping point the fluid is at a predetermined pressure above the ambient pressure.

The fluid tapping point can be an outflow valve, faucet, air outlet, or fuel injection. Generally, fluid tapping points can be locations and/or devices where the fluid is accessed, controlled, and/or redirected within the system. An outflow valve can be configured to control the release of fluid from the system. Thereto precise regulation of fluid discharge can be achieved. The outflow valve can be configured to manage a flow rate and/or pressure of the fluid exiting the system.

In an aircraft, the outflow valve can be used in aircraft pressurization systems, i.e., to maintain cabin pressure by controlling the release of air.

A faucet can be configured to control the outflow of water, preferably from a potable water system, e.g., of an aircraft. The system can be configured to regulate a fluid pressure and/or flow rate when a faucet is used to enable continuous flow through the fluid-flow device. The faucet may be configured to start a fluid dispensing interval, to start, stop, and/or regulate the flow of water.

An air outlet can be configured to distribute air within a space. Thereto, the air outlet can be part of an existing ventilation system, specifically a HVAC (Heating, Ventilation, and Air Conditioning) system. The air outlet can be configured to direct the flow of conditioned air (heated, cooled, and/or ventilated) into cabinets and/or spaces.

A fuel injector can be configured to control the amount and timing of fuel delivery to optimize engine performance and efficiency.

The respective tapping point may have specific functions, components, and/or applications that contribute to the efficient operation of the primary vehicle function, the tapping point is part of. The tapping point can be adjusted in function to allow for fluid flow through the fluid-flow device.

Removing a portion of the fluid can relate to the fluid not being available for recirculation to the fluid-flow device after removal.

In a further embodiment, the fluid-flow device can comprise a mounting plate. The mounting plate can be configured to releasably attach the heat-emitting electronic component to the fluid-flow device .

The mounting plate can be configured to facilitate the transfer of heat from one side to another, i.e. from the first surface to the second surface. It can be made of or comprise a material with high thermal conductivity, such as metal, to efficiently conduct heat. The mounting plate can act as a bracket and/or plate to which the electronic component is attached on one side, while the other side interfaces with the fluid-flow device to remove heat.

The exchange surface refers to the first surface of the mounting plate that comes into contact with the fluid from the fluid-flow device. This surface is responsible for transferring heat from the mounting plate to the fluid, thereby cooling the attached electronic component.

The mounting plate can form a barrier or shield prevent fluid to come in direct contact with the electronic component. The mounting plate can comprise fluid conduits, i.e., the mounting plate can be an integral part of the fluid-flow device.

In a further embodiment, the mounting plate can comprise a cutout section forming an opening in the mounting plate. The fluid-flow device can comprise a conduit section configured to guide the fluid. The heat-emitting electronic component can be configured to attach to the conduit section through the cutout section.

This can achieve the advantage that surface-to-surface heat conduction losses can be minimized. The electronic component can be directly attached to the fluid-flow device.

The exchange surface can be formed by a first surface of the mounting plate. The mounting plate can comprise a second surface which preferably faces away from the first surface. The heat-emitting electronic component can be configured to attach to the second surface. The mounting plate can be configured to conductively transfer heat from the heat-emitting electronic component to the fluid.

In a further embodiment the mounting plate can comprise mounting means which can be configured to provide a form-fit connection between the heat-emitting electronic component and the mounting plate, preferably to provide a predetermined contact pressure between the heat-emitting electronic component and the second surface.

A form-fit connection can be a form-locking or form-closed connection enabling a mechanical connection between two parts where the shapes of the parts interlock and block each other along at least one defined linear or rotational direction. This connection may comprise geometric contact means at the effective surfaces of the parts, ensuring secure attachment, preferably without relying on friction or external forces.

The form-fit connection can ensure that the electronic component remains securely connected, preventing separation or movement in specific directions.

The predetermined contact pressure can refer to a specific amount of pressure applied between two surfaces to ensure effective contact and thereby effective heat transfer.

By providing both a form-fit connection and predetermined contact pressure, the mounting plate ensures that the electronic component remains securely attached and efficiently cooled, enhancing the reliability and performance of the system.

According to a further embodiment, the heat-emitting electronic component can comprise a side panel with an inner surface and an outer surface, a heat source, and heat transfer means. The heat transfer means can be configured to conductively transfer heat from the heat source to the inner surface of the side panel. Furthermore, the outer surface of the side panel can face away from the heat source and is in heat-conductive contact with the fluid-flow device.

The side panel can be any panel of a plurality of panels enclosing the electronic component. Preferably, the side panel is a back panel of the electronic component. Thereto, the side panel can be disposed at a rear end of the electronic component and can face the mounting plate. Advantageously, the side panel can be configured to attach in a surface contacting manner to the mounting plate. The side panel can be a part of an enclosure of the electronic component.

Thereby efficient heat transfer from the internal heat emitting components to the side panel can be achieved. The heat-conductive contact between the outer surface and the fluid-flow device can be achieved via the mounting plate. The heat transfer means can include heat sinks, heat pipes and/or other solid heat conducting structures.

In a further embodiment, the outer surface of the side panel can be configured to come into full-surface contact with the mounting plate when the heat-emitting electronic component is attached to the mounting plate.

Thereby, efficient heat transfer from the side panel to the mounting plate and subsequently to the fluid can be achieved. Preferably, the outer surface and the mounting plate are planar in their area of contact.

In a further embodiment the fluid-flow device can comprise a heat transfer structure configured to increase the surface area of the exchange surface, absorb heat from the mounting plate, and/or dissipate the absorbed heat via its surface area to the fluid.

The heat transfer structure can be a surface structure extending outwards from a flat surface, e.g., the mounting plate. In an example, the heat transfer structure can be a heat sink structure comprising a plurality of flow channels increasing the surface area in contact with the fluid. The heat transfer structure may comprise a body having a plurality of fins, ridges, and/or other protrusions that are configured to increase the bodies surface area. This design may maximize contact with the fluid enhancing heat dissipation.

In a further embodiment, the mounting plate comprises a plurality of mounting means configured to attach a plurality of heat-emitting electronic components to the mounting plate.

This can achieve the advantage that the mounting plate can act as a centralized bracket facilitating mounting and cooling simultaneously. Preferably, the mounting plate can be configured to dissipate heat from a plurality of electronic components throughout its body. Thereby, a centrally attached single fluid-flow device may remove the heat emitted from a plurality of electronic components. Additionally, the mounting plate can be configured to concentrate heat at a predetermined contact point with the fluid. Advantageously, a system of standardized form factors for mounting components to the mounting plate can established. For example, the mounting plate can comprise a grid of standardized mounting points configured to allow the attachment of electronic components of various dimensions.

In a further advantageous embodiment, the system can comprise a heat pump. The heat pump can be disposed between the heat-emitting electronic component and the fluid-flow device. The heat pump can be configured to actively transfer heat from the heat-emitting electronic component to the fluid-flow device.

The heat pump can be a thermo-electric cooler, e.g., a Peltier element. The heat pump can provide precise control over the temperature of the electronic component. By adjusting the current, the amount of heat transferred can be finely tuned, allowing for stable and accurate temperature regulation. Thereto, the temperature of the electronic component can be decoupled from the temperature of the fluid. In particular, the temperature of the electronic component, respectively, the temperature of the heat transfer means within the electronic component, can be lower than the fluid temperature. Further, the heat pump can be configured to operate inversely such that the heat pump can also be used to heat the electronic component, thereby providing versatility in thermal management. Preferably, the temperature of the electronic component can be adjusted to fall within a predetermined temperature interval relative to the ambient temperature around the electronic component to reduce the risk of condensation.

The heat pump can be disposed between the electronic component and the mounting plate. Alternatively, the heat pump can be disposed between the mounting plate and the heat transfer structure. The mounting plate can comprise two separate plates, wherein the heat pump can be disposed between the two separate plates. Thereby, the heat transfer capabilities of the heat pump can be spread over a larger surface area.

The heat pump can be configured to provide localized cooling at a mounting surface of the electronic component to the mounting plate.

In a further embodiment, the system can comprise a plurality of fluid reservoirs. The fluid reservoirs can be interconnected, spaced apart, and/or pressurized. The pump can be configured to provide the heated fluid to at least one of the plurality of reservoirs.

The fluid reservoirs can, for example, include separate water tanks each configured to provide water to a fluid tapping point, e.g., in a lavatory of an aircraft. Pressurizing can relate to keeping the fluid pressure at a range compatible with providing water through faucets or other water dispensing facilities.

The fluid reservoirs can be present in addition to the heat sink. Thereto, the fluid reservoirs can be disposed at different locations of the vehicle, preferably in proximity to a fluid tapping point.

A fluid reservoir can be disposed in an in an unpressurized and/or non-temperature controlled area. By providing the heated fluid to a reservoir in a non-temperature controlled area, the fluid can be prevented from freezing, in particular during operation (e.g., aircraft at high altitude). Preferably, the system can use the excess heat from the electronic component to heat the fluid, reducing the need to provide additional heating means or render additional heating obsolete.

In a further embodiment, the can be potable water. The system can comprise a temperature control means configured to increase the temperature of the fluid volume within the heat sink to a temperature above a predetermined temperature threshold value, in particular above the freezing point of the fluid, according to ambient parameters by controlling the flow of the fluid, in particular the flow of the heated fluid, within the system.

The predetermined temperature threshold value can be a lower optimal temperature limit for the fluid. For example, an optimal working temperature for the fluid in its capacity as the working fluid in the primary vehicle function. Ambient parameters like ambient temperature and/or ambient pressure can determine the actual value of the lower optimal temperature limit.

The system can be configured to control the heat output to achieve a sufficient heat transfer from the electronic component to the fluid. For example, the temperature control means can be configured to control the execution of functions of the electronic component that generate excess heat. Thereby, the temperature control means can be configured to control the fluid temperature. The heat pump can be configured to cool the electronic component below a required target temperature, i.e., provide excess cooling, to provide additional heat to the liquid. Thereby, should the fluid reach a critical temperature within the heat sink and/or a fluid reservoir that may cause freezing of the fluid, additional heat can be generated to reach a fluid temperature above the critical temperature.

Advantageously, controlling the flow of the fluid within the system can comprise controlling a fluid flow rate. Thereto, the temperature control means can be configured to adjust the fluid transport device to control the flow rate through the fluid flow device. Additionally or alternatively, controlling the flow can comprise directing the heated fluid within the system, preferably such that a heat input to the thermal sink can be increased, in particular maximized. For example, depending on the fluid temperature within each of the fluid reservoirs, the temperature control means can be configured to adjust the amount of heated fluid flowing to each fluid reservoir, respectively the heat sink. Thereby, the temperature of the fluid can be controlled to be below a predetermined temperature limit, in particular at a fluid tapping point.

In an embodiment, the fluid reservoirs can be fuel reservoirs.

In a further embodiment, the fluid can be air. The thermal sink can be a vehicle compartment. The temperature control means can be configured to control a temperature within the vehicle compartment at least in part by controlling an eject rate of the fluid, in particular of the heated fluid, into the vehicle compartment, preferably via the fluid tapping point. Thereto, the fluid tapping point can be a ventilation opening, e.g., an adjustable air flow opening.

The fluid reservoir can be a passenger cabin, preferably a passenger cabin of an aircraft.

The fluid tapping point can be an air outlet or air vent. The fluid-flow device can be configured for passive convection to enable heat dissipation within the vehicle compartment. The fluid-flow device can be integrated into a climatization system of the vehicle as a heat source.

In a further embodiment, the system can comprise a fluid extractor configured to extract fluid from a vehicle compartment and provide the extracted fluid to the fluid-flow device.

The vehicle compartment can form the heat sink holding a large volume of fluid. The fluid extractor can be a ventilation device, pump. The fluid extractor may use a pressure difference between the vehicle compartment and the fluid pressure withing the fluid-flow device to guide fluid towards the fluid-flow device. The fluid extractor may be configured to generate a reduced pressure at the fluid-flow device.

### BRIEF DESCRIPTION OF THE DRAWINGS

The subject matter will hereinafter be described in conjunction with the following drawing figures, wherein like numerals denote like elements, and wherein:
- Fig. 1: is a schematic perspective representation of an electronic component attached to a fluid-flow device in accordance with an embodiment;
- Fig. 2: is a schematic side view of an electronic component in accordance with an embodiment;
- Fig. 3: is a schematic perspective view of an electronic component attached to a mounting plate and a fluid-flow device attached to an opposite side of the mounting plate in accordance with an embodiment;
- Fig. 4: is a schematic front view of an electronic component, a fluid-flow device and a mounting plate attached to each other in accordance with an embodiment;
- Fig. 5: is a schematic front view of an electronic component, a fluid-flow device and a mounting plate attached to each other in accordance with an embodiment;
- Fig. 6: is a schematic side view of an electronic component, a fluid-flow device and a mounting plate attached to each other in accordance with an embodiment; and
- Fig. 7: is a schematic representation of a fluid flow system in accordance with an embodiment.

### DETAILED DESCRIPTION OF THE DRAWINGS

The following detailed description is merely exemplary in nature and is not intended to limit the invention and uses of the invention. Furthermore, there is no intention to be bound by any theory presented in the preceding background or the following detailed description.

The representations and illustrations in the drawings are schematic and not to scale. Like numerals denote like elements.

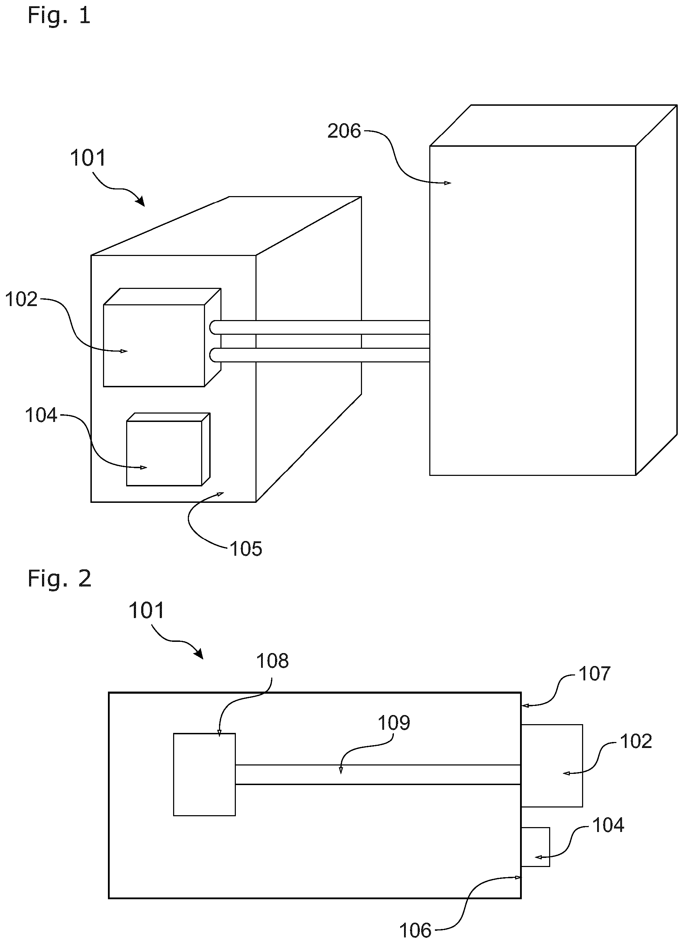

Fig.1 depicts a schematic perspective representation of an electronic component 101 attached to a fluid-flow device 102 according to an embodiment of the disclosure. The fluid-flow device 102 can be a separate cooling block mounted to the electronic component 101.

Further, the electronic component can comprise connector panel 104 to mechanically and/or electronically contact the electronic component 101. The connector panel 104 and the fluid-flow device 102 can be disposed on the same side panel 105 of the electronic component 101. The electronic component 101 can be approximately box-shaped and the fluid-flow-device 102 can be attached at a front side, respectively a back side of the electronic component. The electronic component can be slot-shaped to allow the formation of a stack, e.g., row, column or grid of a plurality of electronic devices 101. Corresponding fluid-flow devices 102 of the plurality of electronic devices 101 can face the same direction.

The fluid flow device 102 can be connected to a heat sink 206. The thermal sink 206 can comprise a large body of fluid. Thereto, the thermal sink 206 can be a cabin compartment filled with air. Alternatively the thermal sink 206 can be a tank comprising a liquid which can circulate through the fluid flow device 102 to absorb heat.

Fig. 2 depicts a schematic side view of an electronic component 101 according to an embodiment of the disclosure. The heat-emitting electronic component 101 comprises a side panel 105 with an inner surface 106 and an outer surface 107. The electronic component 101 further comprises a heat source 108. The heat source can be any type of electronic device and/or a specific component which is connected to a heat transfer means 109. The heat transfer means is configured to conductively transfer heat from the heat source 108 to the inner surface 106 of the side panel 105. The outer surface 107 of the side panel 105 faces away from the heat source 108 and is in heat-conductive contact with the fluid-flow device 102. Alternatively, the heat transfer means 109 can comprise a contacting plate for the fluid-flow device 102 such that the fluid flow device 102 can be directly mounted to the heat transfer means. For example, the heat transfer means 109 can be a metal structure and/or heat pipe directly connecting the heat source 108 with the fluid-flow device 102. Preferably, without further surface to surface contacts at the side panel 105. The fluid-flow device 102 can be configured to directly attach to an inflow fluid line and an outflow fluid line. A plurality of fluid-flow devices may be connected in series or in parallel.

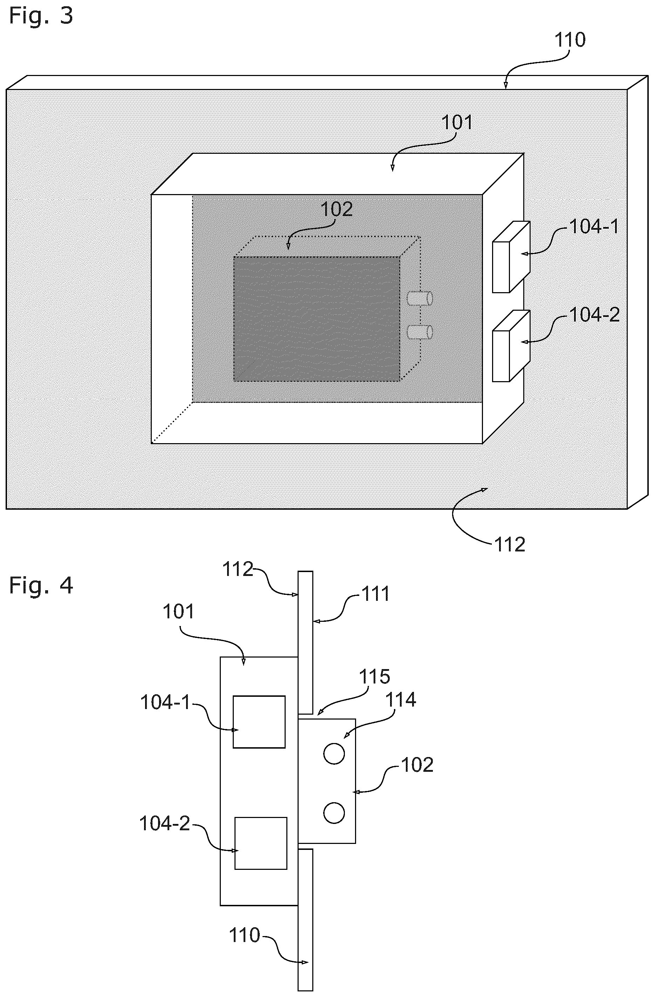

Fig. 3 shows a schematic perspective view of an electronic component 101 attached to a mounting plate 110 and the fluid-flow device 102 attached to an opposite side of the mounting plate 110 according to the disclosure.

The electronic component 101 can be mounted to the mounting plate 110 with a surface of maximal surface area. This may increase the heat transfer capacity between the electronic component 101 and the mounting plate 110. The connector panel may comprise a plurality of separate connectors 104-1, 104-2. Preferably, the mounting plate 110 extends past the limits of the surface of the electronic component 101 in contact with the mounting plate 110. Thereby, the mounting plate can form a barrier between the electronic component 101 and the fluid-flow device 102. Preferably, also the fluid-flow device 102 can be attached to the mounting plate 110 at an outer surface of the fluid-flow device 102 with maximal surface area to increase heat transfer capacity between the fluid-flow device 102 and the mounting plate 110. The mounting plate 110 can have a substantial thickness to allow secure mounting of the electronic component 101 and the fluid-flow device 102. The mounting plate 110 can be configured to fluidly isolate the electronic component 101 from the fluid, respectively the fluid-flow device 102.

The mounting plate 110 can be a structural component of the vehicle configured to bear loads and/or provide a mounting structure for a plurality of components.

The mounting plate 110 can comprises a cutout section 115 forming an opening in the mounting plate 110. The fluid-flow device 102 can comprise a conduit section 114 configured to guide the fluid such that heat can be continuously transported away from the fluid-flow device 102. The heat-emitting electronic component 10i1 can be configured to attach directly to the conduit section 114 through the cutout section 115.

Fig. 4 shows a schematic front view of the electronic component 101, the fluid-flow device 102 and the mounting plate 110 attached to each other according to an embodiment of the disclosure.

The mounting plate 110 comprises a second surface 112 facing away from the first surface 111. The heat-emitting electronic component 101 is configured to attach to the second surface 112.

Providing fluid flow lines and respective inlets and outlets to the fluid-flow device can be dependent on existing fluid lines according to the primary purpose of the fluid. Thereto, the fluid-flow device 102 can be integrated inline into an existing line. The fluid-flow device 102 can be configured to maintain the original fluid flow direction with reference to the vehicle. Alternatively, when providing inlet and outlet at the same side of the fluid-flow device, the direction of fluid flow relative to the vehicle can be inversed. Generally, any geometric configuration at the fluid-flow device 102 can be realized to minimize alterations to the primary fluid system.

The mounting plate 110 can be configured to decouple the mounting orientation of the electronic component 101 from the mounting orientation of the fluid-flow device 102. Thus, the electronic component 101 can be rotated on the surface of the mounting plate 110 to optimize electrical and/or mechanical connections. Advantageously, the surface of the electronic component 101 configured for heat exchange with the mounting plate 110, respectively the fluid-flow device 102 remains in contact with the mounting plate 110 independent of the orientation of the electronic component 101.

The first surface 111 can be configured to accommodate a plurality of fluid-flow devices 102. The second surface 112 can be configured to accommodate a plurality of electronic components 101.

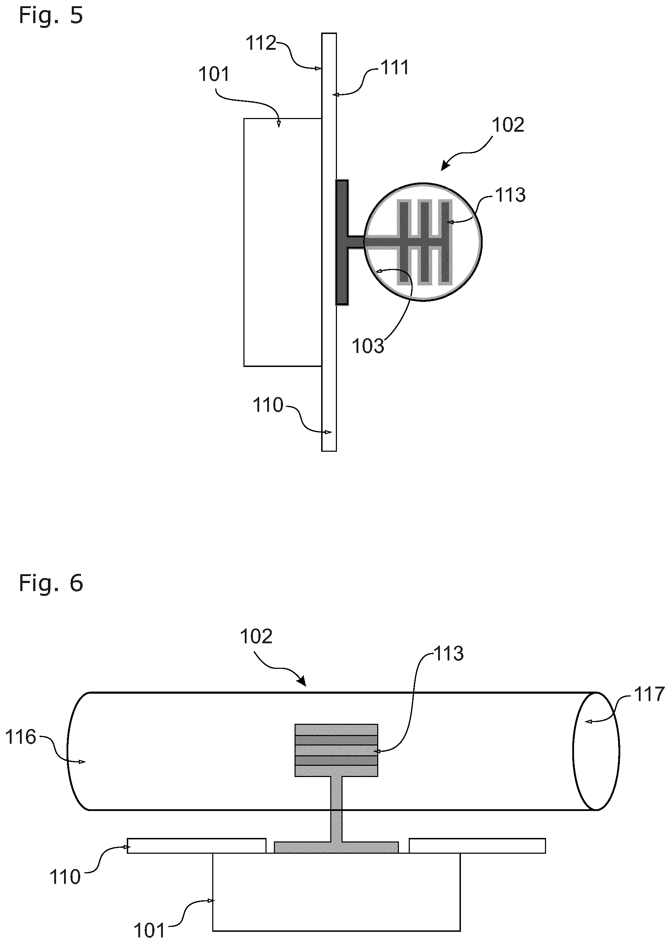

Fig. 5 shows a schematic front view of the electronic component 101, the fluid-flow device 102 and the mounting plate 110 attached to each other according to a further embodiment of the present disclosure. The fluid-flow device 102 comprises a heat transfer structure 113 configured to increase the surface area of the exchange surface 103, absorb heat from the mounting plate 110, and dissipate the absorbed heat via its surface area to the fluid.

The heat transfer structure 112 can be configured to increase the surface roughness of the exchange surface 103. Additionally or alternatively, the heat transfer structure 113 can be a finned structure with fins oriented along a flow direction of the fluid. Each fin can increase the surface area in contact with the fluid, increasing the heat transfer capability of the fluid-flow device 102. The exchange surface is marked as a light grey contour within the fluid-flow device 102 to indicate the increased surface area. The heat transfer structure 113 can be integrated and/or disposed in a fluid conduit, respectively fluid pipe. The heat transfer structure 113 can be directly attached to the mounting plate 111. The heat transfer structure can be optimized to transfer heat according to the specific parameters of the fluid, e.g., density, viscosity, temperature difference between the heat transfer structure and the fluid).

Fig. 6 shows a schematic side view of the electronic component 101, the fluid-flow device 102 and the mounting plate 110 attached to each other according to an embodiment of the disclosure. In this embodiment, the heat transfer structure 113 can be directly mounted to the electronic component 101. The heat transfer structure can comprise a heat pipe configured to transfer heat from the electronic component 101 to the exchange surface 103. The fluid-flow device 102 can comprises an inlet 116 configured to receive fluid and an outlet 117 configured to eject the fluid,

The fluid-flow device 102 can have a pipe-like structure. Preferably a plurality of heat transfer structures 113 can be embedded in the fluid-flow device 102, in particular at locations where electronic components 101 are mounted. The heat transfer structure 113 can be configured to attach a pipe section of the fluid-flow device 102 to the mounting plate 110. The fluid-flow device 102 can comprise a pipe section compatible with an existing primary fluid conduit in the vehicle. A heat transfer to the fluid can then be achieved by coupling the heat transfer structure 113 into the fluid stream of the pipe-section. Advantageously, the pipe section can be an original pipe section used to transfer fluid according to the primary purpose of the fluid. Thermally coupling the electronic component 101 to the fluid can be achieved by integrating the heat transfer structures 113 into an existing pipe section. An existing pipe can be rerouted with minimal effort to allow integration as a fluid-flow device, respectively to integrate the heat transfer structures 113.

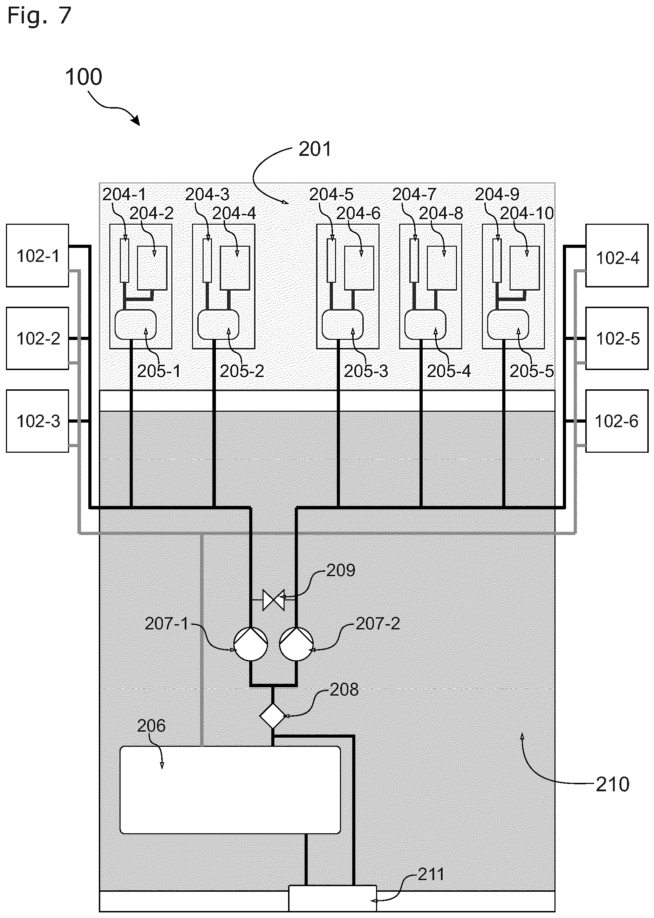

Fig. 7 shows a schematic representation of a system 100 according to the invention. Cooling of electronic components 101-1 to 101-6 can be achieved via liquid cooling based on the potable water system of an aircraft. A cabin section 201 of the aircraft may comprise a plurality of compartments or stations configured to dispense potable water. For example, the aircraft may comprise a plurality of galleys 202-1, 202-2 and/or lavatories 203-1, 203-2, 203-3. These stations may comprise at least one fluid tapping point 204-1 to 204-10. Additionally, each lavatory, respectively galley may comprise a fluid reservoir 205-1 to 205-5. Each reservoir 205 can be fed by a water provisioning system. The system can be configured to intermittently or continuously circulate the water. Preferably circulation is achieved between at least the respective fluid-flow devices 102-1 to 102-6 attached to corresponding electronic components and the heat sink, specifically the potable water tank 206.

The system 100 can comprise a pump 207-1 and preferably a second pump 207-2. The system can comprise a plurality of pumps wherein each pump is configured to feed a predetermined section of the vehicle. For example a first pump 207-1 may feed a fluid loop at the forward section of an aircraft and a second pump 207-2 may feed a fluid loop at the aft section of the aircraft. Thereto, the fluid flow can be divided into a plurality of individual circuits. Each fluid-flow device 102 can be integrated in parallel having an individual inlet and an individual outlet. Backflow from the individual outflows may be directed towards the heat sink 206.

Each of the individual fluid reservoirs 205-1 to 205-5 can serve as a buffer for providing fluid via the respective fluid tapping points 204-1 to 204-10.

The system 100 can comprise a fluid filter 208 upstream of the pump 207. The system may further comprise a cross-feed module 209 configured to equalize flow between a plurality of fluid loops fed by the respective pumps. The fluid flow conduits can be integrated in a floor section 210 of the aircraft. Filling access to the water tank 206, respectively the complete fluid system can be achieved by an external service panel at the hull 211 of the aircraft. Preferably, the fluid system can be a high pressure water system in a commercial aircraft. High pressure water pipe can be used to connect the component of the system 100.

## Claims

1. Fluid flow system (100) for a fluid with dual purpose in a vehicle, comprising a heat-emitting electronic component (101), configured to attach to a fluid-flow device (102) in a heat-transferring manner;
the fluid-flow device (102) having an exchange surface (103) in contact with the fluid, wherein the fluid-flow device (102) is configured to:
guide the fluid; and
transfer heat from the exchange surface (103) to the fluid to generate heated fluid;
a thermal sink (206) configured to:
hold a fluid volume;
intake the heated fluid from the fluid-flow device (102); and
dissipate the heat of the heated fluid in the fluid volume;
wherein the fluid is configured to enable a primary vehicle function which is independent from absorbing heat from the heat-emitting electronic component (101).

2. Fluid flow system (100) according to any one of the preceding claims,
wherein the fluid-flow device (102) is configured to generate a convective fluid flow through the fluid-flow device (102) based on a temperature difference between the exchange surface (103) and the fluid in the fluid-flow-device (102).

3. Fluid flow system (100) according to anyone of the preceding claims, comprising a fluid transport device (207), configured to generate a fluid flow and loop the fluid between the fluid-flow device (102) and the thermal sink (206).

4. Fluid flow system (100) according to claim 3,
wherein the fluid-flow device (102) comprises an inlet configured to receive fluid, and an outlet configured to eject the fluid, and
wherein the fluid transport device (207) is configured to:
- provide at least part of the fluid to the inlet from a vehicle exterior, and
- recirculate at least part of the fluid exiting the outlet to the inlet via the thermal sink (206).

5. Fluid flow system (100) according to any one of claims 3 to 4,
comprising a fluid tapping point (204) configured to remove a portion of the fluid from the fluid flow system (100),
wherein the fluid transport device (207) is configured to apply a pressure to downstream fluid that exceeds ambient pressure of the fluid-flow system (100) such that at least at the fluid tapping point (204) the fluid is at a predetermined pressure above the ambient pressure.

6. Fluid flow system (100) according to any one of the preceding claims,
wherein the fluid-flow device (102) comprises a mounting plate (110) configured to releasably attach the heat-emitting electronic component (101) to the fluid-flow device (102).

7. Fluid flow system (100) according to claim 6,
wherein the mounting plate (110) comprises a cutout section (115) forming an opening in the mounting plate (110);
wherein the fluid-flow device (102) comprises a conduit section (114) configured to guide the fluid; and
wherein the heat-emitting electronic component (101) is configured to attach to the conduit section (114) through the cutout section (115).

8. Fluid flow system (100) according to any one of claims 6 to 7,
wherein the exchange surface (103) is formed by a first surface (111) of the mounting plate (110),
wherein the mounting plate (110) comprises a second surface (112) facing away from the first surface (111),
wherein the heat-emitting electronic component (101) is configured to attach to the second surface (112), and
wherein the mounting plate (110) is configured to conductively transfer heat from the heat-emitting electronic component (101) to the fluid.

9. Fluid flow system (100) according to any one of claims 6 to 8,
wherein the mounting plate (110) comprises mounting means configured to
provide a form-fit connection between the heat-emitting electronic component (101) and the mounting plate (110) to provide a predetermined contact pressure between the heat-emitting electronic component (101) and the second surface (112).

10. Fluid flow system (100) according to any one of the preceding claims,
wherein the heat-emitting electronic component (101) comprises
a side panel (105) with an inner surface (106) and an outer surface (107),
a heat source (108),
and heat transfer means (109),
wherein the heat transfer means (109) is configured to:
conductively transfer heat from the heat source (108) to the inner surface of the side panel (106), and
wherein the outer surface (107) of the side panel (105) faces away from the heat source (108) and is in heat-conductive contact with the fluid-flow device (102).

11. Fluid flow system (100) according to any one of claims 6 to 9, and claim 10,
wherein the outer surface (107) of the side panel (105) is configured to:
come into full-surface contact with the mounting plate (110) when the heat-emitting electronic component (101) is attached to the mounting plate (110).

12. Fluid flow system (100) according to claim 6,
wherein the fluid-flow device (102) comprises a heat transfer structure (113) configured to:
increase the surface area of the exchange surface (103),
absorb heat from the mounting plate (110), and
dissipate the absorbed heat via its surface area to the fluid.

13. Fluid flow system (100) according to any one of the preceding claims,
comprising a heat pump disposed between the heat-emitting electronic component (101) and the fluid-flow device (102),
wherein the heat pump is configured to:
actively transfer heat from the heat-emitting electronic component (101) to the fluid-flow device (102).

14. Fluid flow system (100) according to any one of the preceding claims,
wherein the fluid flow system (100) comprises a temperature control means configured to increase the temperature of the fluid volume within the heat sink (206) to a temperature above a predetermined temperature threshold value by controlling the flow of the fluid within the fluid flow system (100).

15. Fluid flow system (100) according to any one of the preceding claims 1 to 13,
wherein the fluid is air,
wherein the thermal sink (206) is a vehicle compartment, and
wherein the fluid flow system (100) further comprises a temperature control means configured to control a temperature within the vehicle compartment at least in part by controlling an eject rate of the fluid into the vehicle compartment.
